# FASCICULE DE BREVET EUROPEEN

(11) **EP 3 487 167 B1**
(45) Date de publication et mention de la délivrance du brevet: **11.03.2020**
(21) Numéro de dépôt: 18200657.7
(22) Date de dépôt: 16.10.2018
(51) Int. Cl.: H04N 5/3745, H04N 5/359

(54) **CAPTEUR D'IMAGES À GRANDE GAMME DYNAMIQUE**
BILDERFASSUNGSSENSOR MIT SEHR HOHER DYNAMISCHER BANDBREITE
IMAGE SENSOR WITH HIGH DYNAMIC RANGE

(30) Priorité: 21.11.2017 FR 1760992
(43) Date de publication de la demande: 22.05.2019
(73) Titulaire: Commissariat à l'Energie Atomique et aux Energies Alternatives, 75015 Paris (FR)
(72) Inventeur: PEIZERAT, Arnaud, 38000 GRENOBLE (FR)
(74) Mandataire: Cabinet Beaumont

(56) Documents cités:
- EP-A1- 3 139 595
- US-A1- 2009 261 235
- US-B2- 7 514 716
- SUNG-HYUN YANG ET AL: "High dynamic range CMOS image sensor with conditional reset", PROCEEDINGS OF THE IEEE 2002 CUSTOM INTEGRATED CIRCUITS CONFERENCE. (CICC 2002). ORLANDO, FL, MAY 12 - 15, 2002., 2002, pages 265-268, XP055484666, US DOI: 10.1109/CICC.2002.1012810 ISBN: 978-0-7803-7250-4

## Description

### Domaine

La présente invention concerne un capteur d'images, ou dispositif imageur, à grande gamme dynamique. Elle s'applique notamment aux imageurs CMOS réalisés en technologie silicium comportant des pixels de petite taille et adaptés à réaliser une détection optique dans le domaine visible.

### Exposé de l'art antérieur

Un capteur d'images à grande gamme dynamique est un capteur d'images conçu pour être sensible à une dynamique de luminance étendue dans une même image acquise par ses capteurs photosensibles. L'image acquise n'est ainsi ni surexposée dans ses zones de forte intensité lumineuse, ni sous-exposée dans ses zones de faible intensité lumineuse : elle comporte une information détaillée à la fois dans ces deux types de zones extrêmes de l'image. La dynamique du capteur d'images peut être augmentée en réduisant le bruit plancher des pixels ou en augmentant la limite de saturation des pixels.

Le capteur d'images peut mettre en oeuvre un procédé appelé procédé d'extension de dynamique qui permet au capteur d'images d'accepter des luminosités plus élevées que celles qui seraient acceptées en tenant compte seulement de la limite de saturation des pixels.

On appelle phase d'intégration d'un pixel la phase pendant laquelle le pixel collecte des charges sous l'action d'un rayonnement incident. La phase d'intégration est généralement suivie d'une phase de lecture pendant laquelle une mesure de la quantité de charges collectées par le pixel est réalisée. Pour certaines applications, il peut être souhaitable que le capteur d'images soit du type à obturateur global, également appelé Global Shutter, c'est-à-dire mettant en oeuvre un procédé d'acquisition d'images dans lequel les débuts et fins des phases d'intégration des pixels sont simultanés.

Pour certaines applications, il peut être souhaitable de réaliser, simultanément à une phase d'intégration d'un pixel, une phase de lecture pendant laquelle il est mesuré la quantité de charges collectées par le pixel pendant la phase d'intégration précédant la phase d'intégration en cours. Un tel procédé est appelé procédé IWR, sigle anglais pour Integrating While Reading. Un tel procédé permet d'augmenter la vitesse du capteur d'images, c'est-à-dire le nombre d'images acquises par seconde ou FR, sigle anglais pour Frame Rate ou FPS, sigle anglais pour Frame Per Second.

Le brevet US 7 514 716 décrit un capteur d'images mettant en oeuvre un procédé d'extension de dynamique. Ce procédé consiste à mesurer la quantité de charges stockées dans un pixel du capteur d'images à des instants donnés pendant la phase d'intégration du pixel, à comparer les valeurs mesurées à un seuil et à réinitialiser ou non le pixel selon le résultat de cette comparaison. Lorsque le pixel est réinitialisé, une donnée représentative du temps d'intégration écoulé au moment de la réinitialisation est mémorisée. Un inconvénient du procédé d'extension de dynamique décrit dans le brevet US 7 514 716 est que la donnée représentative du temps d'intégration au moment d'une réinitialisation est stockée de manière analogique sur le noeud de lecture du pixel. Il n'est alors pas possible de mettre en oeuvre un procédé IWR.

### Résumé

Ainsi, un objet d'un mode de réalisation est de prévoir un capteur d'images qui pallie au moins certains des inconvénients des capteurs d'images décrits précédemment.

Un autre objet d'un mode de réalisation est que la dynamique du capteur d'images est augmentée.

Un autre objet d'un mode de réalisation est que le capteur d'images mette en oeuvre un procédé d'extension de dynamique.

Un autre objet d'un mode de réalisation est que le capteur d'images est du type Global Shutter.

Un autre objet d'un mode de réalisation est que le capteur d'images mette en oeuvre un procédé de lecture des pixels du type IWR.

Un autre objet d'un mode de réalisation est que la structure du pixel n'est pas modifiée par rapport à un capteur d'images du type Global Shutter.

Ainsi, un mode de réalisation prévoit un capteur d'images comprenant des pixels, chaque pixel comprenant un photodétecteur et un circuit de lecture de la quantité de charges collectées par le photodétecteur à la fin d'une phase de collecte de charges par le photodétecteur, le capteur d'images comprenant en outre, pour au moins l'un des pixels, un circuit de détection adapté, au moins à chacun de deux instants différents pendant ladite phase, à détecter si la quantité de charges collectées audit instant par le photodétecteur dudit pixel dépasse un seuil et, dans le cas où ladite quantité de charges collectées audit instant dépasse le seuil, à mémoriser un premier signal représentatif dudit instant et à réinitialiser le photodétecteur.

Selon un mode de réalisation, pour chaque pixel, le circuit de lecture comprend au moins un premier transistor reliant le photodétecteur à un premier noeud et chaque pixel comprend, en outre, un deuxième transistor reliant le photodétecteur à un deuxième noeud, ledit deuxième noeud d'au moins l'un des pixels étant relié au circuit de détection.

Selon un mode de réalisation, le capteur d'images comprend, en outre, un troisième transistor reliant le deuxième noeud à une source d'un premier potentiel de référence.

Selon un mode de réalisation, le circuit de détection est adapté, pour chacun desdits instants, à rendre au moins partiellement passant le deuxième transistor, le troisième transistor étant alors non passant, puis à rendre passants le deuxième transistor et le troisième transistor dans le cas où la quantité de charges collectées audit instant dépasse ledit seuil.

Selon un mode de réalisation, le capteur d'images comprend un comparateur et un circuit de commande du deuxième transistor à partir du signal fourni par le comparateur.

Selon un mode de réalisation, le capteur d'images comprend une première source d'un premier signal discret de plusieurs premiers niveaux et le circuit de détection est adapté à commander le deuxième transistor avec l'un desdits premiers niveaux en fonction dudit instant.

Selon un mode de réalisation, le circuit de détection comprend un circuit de mémorisation du premier signal représentatif dudit instant, dans le cas où la quantité de charges collectées audit instant dépasse ledit seuil, le premier signal étant un signal analogique ou un signal numérique.

Selon un mode de réalisation, le circuit de mémorisation comprend une deuxième source d'un deuxième signal discret de plusieurs deuxièmes niveaux, au moins un condensateur et un circuit de charge du condensateur avec l'un desdits deuxièmes niveaux en fonction dudit instant, dans le cas où la quantité de charges collectées audit instant dépasse ledit seuil.

Selon un mode de réalisation, pour chaque pixel, le circuit de lecture comprend un quatrième transistor MOS dont la grille est reliée au premier noeud et le circuit de détection comprend un cinquième transistor MOS dont la grille est reliée au deuxième noeud.

Selon un mode de réalisation, le circuit de détection comprend un premier interrupteur reliant l'une des bornes entre la source et le drain du cinquième transistor MOS à la source du premier potentiel de référence et un deuxième interrupteur reliant l'autre borne entre la source et le drain du cinquième transistor MOS à une source d'un deuxième potentiel de référence.

Un mode de réalisation prévoit également un procédé d'acquisition d'images par un capteur d'images comprenant des pixels, chaque pixel comprenant un photodétecteur et un circuit de lecture de la quantité de charges collectées par le photodétecteur à la fin d'une phase de collecte de charges par le photodétecteur, le procédé comprenant les étapes suivantes réalisées pour au moins l'un des pixels :
a) détecter, au moins à chacun de deux instants différents pendant ladite phase, si la quantité de charges collectées audit instant par le photodétecteur dudit pixel dépasse un seuil ; et
b) dans le cas où la quantité de charges collectées audit instant par le photodétecteur dépasse le seuil, mémoriser un premier signal représentatif dudit instant et réinitialiser le photodétecteur.

Selon un mode de réalisation, pour chaque pixel, le circuit de lecture comprend au moins un premier transistor reliant le photodétecteur à un premier noeud. Chaque pixel comprend, en outre, un deuxième transistor reliant le photodétecteur à un deuxième noeud, ledit deuxième noeud d'au moins l'un des pixels étant relié au circuit de détection. A l'étape a), à chacun desdits instants, le deuxième transistor est rendu au moins partiellement passant, le premier transistor étant non passant, et, à l'étape b), dans le cas où la quantité de charges collectées audit instant dépasse ledit seuil, le deuxième transistor est rendu passant pour réinitialiser le photodétecteur.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est un schéma électrique partiel d'un capteur d'images ;
la figure 2 est un schéma électrique partiel d'un pixel d'un capteur d'images du type Global Shutter ;
les figures 3 et 4 sont des chronogrammes de signaux de commande de deux pixels ayant la structure représentée en figure 2, selon deux modes de fonctionnement du capteur d'images ;
la figure 5 est un schéma électrique partiel d'un mode de réalisation d'un capteur d'images mettant en oeuvre un procédé d'extension de dynamique ;
la figure 6 est un chronogramme de signaux de commande selon un mode de réalisation d'un procédé de fonctionnement du capteur d'images représenté en figure 5 ;
la figure 7 est une courbe d'évolution, obtenue par simulation, du nombre d'électrons reçus au noeud de lecture SN du pixel représenté en figure 5 en fonction du nombre total d'électrons reçus par la photodiode du pixel ;
la figure 8 est un schéma électrique partiel d'un mode de réalisation plus détaillé du capteur d'images de la figure 5 ;
la figure 9 est un chronogramme de signaux de commande selon un mode de réalisation d'un procédé de fonctionnement du capteur d'images représenté en figure 8 ; et
la figure 10 illustre des niveaux de tension de transistors du capteur d'images représenté en figure 8 à différents instants successifs.

### Description détaillée

Dans la suite de la description, seuls les éléments nécessaires à la compréhension de l'invention seront décrits et représentés sur les figures. En particulier, les circuits de traitement des signaux lus dans les pixels sont bien connus de l'homme du métier et ne sont pas décrits par la suite. De plus, on appelle "signal binaire" un signal qui alterne entre un premier état constant, par exemple un état bas, noté "0", et un deuxième état constant, par exemple un état haut, noté "1". Les états haut et bas de signaux binaires différents d'un même circuit électronique peuvent être différents. En pratique, les signaux binaires et les signaux discrets peuvent correspondre à des tensions ou à des courants qui peuvent ne pas être parfaitement constants à l'état haut ou bas. De plus, on appelle "signal discret" un signal qui ne peut prendre que des valeurs sensiblement constantes parmi un ensemble fini de valeurs. En outre, les expressions "sensiblement", "environ", "approximativement" et "de l'ordre de" signifient "à 10 % près".

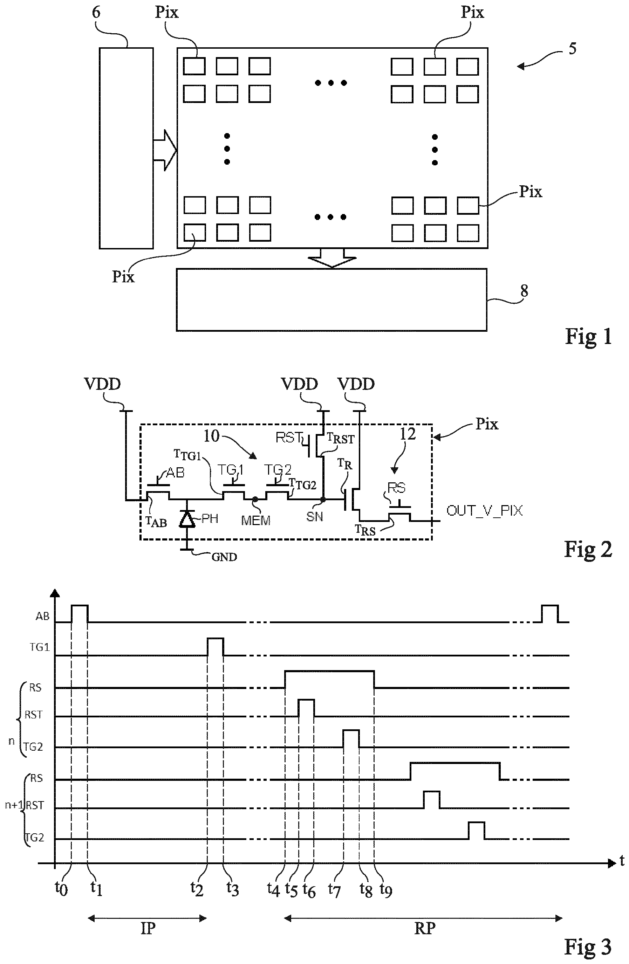

La figure 1 est un schéma électrique d'un capteur d'images 5 comprenant des pixels Pix, par exemple agencés en lignes et en colonnes, un circuit 6 de commande adapté notamment à sélectionner successivement chaque ligne de pixels et un circuit 8 de lecture des signaux stockés dans les pixels de la ligne sélectionnée.

La figure 2 est un schéma électrique d'un exemple de pixel Pix du capteur d'images 5. Le pixel Pix représenté en figure 2 est adapté pour la réalisation d'un capteur d'images 5 du type Global Shutter.

Le pixel Pix correspond à un pixel dit "6T", c'est-à-dire présentant une électronique analogique formée par six transistors à effet de champ à structure métal-oxyde-semiconducteur, ou transistors MOS.

Le pixel Pix comprend un photodétecteur PH, par exemple une photodiode, notamment une photodiode pincée (en anglais pinned photodiode), destiné à convertir l'énergie de photons incidents reçus en paires électrons-trous. A titre de variante, le photodétecteur PH peut être un phototransistor. Dans le présent exemple, l'anode de la photodiode PH est reliée à une source d'un potentiel de référence bas GND, par exemple la masse.

Le pixel Pix comprend également un circuit de lecture 10 des charges générées par la photodiode PH. Le circuit de lecture 10 comprend notamment un circuit assurant la charge et la décharge de la photodiode PH ainsi que la conversion des charges générées par la photodiode PH et stockées dans sa capacité de jonction pendant la phase d'intégration du pixel Pix.

Enfin, le pixel Pix comprend également un circuit 12 de sélection de ligne fournissant un signal OUT_V_PIX et permettant, sur réception d'un signal RS correspondant à la ligne sur laquelle se trouve le pixel Pix et en fonction de la valeur de ce signal RS, de lire les informations de luminance stockées par le pixel Pix pendant son temps d'intégration.

Le circuit 12 de sélection de ligne comprend par exemple un transistor MOS T_{RS}, par exemple à canal N, dont la source fournit le signal OUT_V_PIX. Le circuit de lecture 10 peut comporter un transistor MOS T_{RST}, par exemple à canal N, dont la source est reliée à un noeud de lecture SN, dont le drain est relié à une source d'un potentiel de référence haut VDD et dont la grille reçoit un signal RST. Il comporte en outre un transistor MOS T_{R}, par exemple à canal N, dont le drain est relié à la source du potentiel haut VDD et dont la source est reliée au drain du transistor T_{RS} de sélection de ligne. Par ailleurs, la grille du transistor T_{R} est reliée au noeud de lecture SN. Le circuit de lecture 10 peut, en outre, comporter un transistor MOS T_{TG1}, par exemple à canal N, dont le drain est relié à la cathode de la photodiode PH, dont la source est reliée à un noeud MEM et dont la grille reçoit un signal TG1. Le circuit de lecture 10 peut en outre comporter un transistor MOS T_{TG2}, par exemple à canal N, dont le drain est relié au noeud MEM, dont la source est reliée au noeud SN et dont la grille reçoit un signal TG2.

Le pixel Pix peut en outre comporter un transistor MOS T_{AB}, par exemple à canal N, dont le drain est relié à la source du potentiel haut VDD, dont la source est reliée à la cathode de la photodiode PH, et dont la grille reçoit un signal AB.

Les signaux de commande de grille AB, TG1, TG2, RS et RST sont fournis par le circuit de commande 6, non représenté en figure 2.

La figure 3 est un chronogramme illustrant un mode de réalisation d'un procédé de fonctionnement du capteur d'images 5. On appelle t₀ à t₉ des instants successifs.

A l'instant t₀, le transistor T_{AB} est mis à l'état passant simultanément pour chaque pixel Pix du capteur d'images 5. Ceci permet de réinitialiser le pixel Pix, la tension aux bornes de la capacité de jonction de la photodiode PH étant alors égale à la tension de pincement de la photodiode.

A l'instant t₁, le transistor T_{AB} est mis à l'état non passant pour chaque pixel Pix du capteur d'images 5. Ceci correspond au début d'une phase d'intégration IP pour chaque pixel Pix. La lumière qui atteint le photodétecteur entraîne la formation de paires électrons/trous, le stockage des électrons dans la capacité de jonction de la photodiode PH et une diminution de la tension aux bornes de la photodiode PH. Les transistors T_{AB} et T_{TG1} sont dimensionnés de sorte que, lorsque la photodiode PH atteint sa limite de saturation, les électrons supplémentaires sont évacués par le transistor T_{AB} et non par le transistor T_{TG1}.

A l'instant t₂, le transistor T_{TG1} est mis à l'état passant simultanément pour chaque pixel Pix du capteur d'images 5. Les charges stockées dans la photodiode PH sont au moins partiellement transférées au noeud MEM. Ceci correspond à la fin de la phase d'intégration IP pour chaque pixel Pix.

A l'instant t₃, le transistor T_{TG1} est mis à l'état non passant simultanément pour chaque pixel Pix du capteur d'images 5. Le noeud MEM conserve les charges transmises par la photodiode PH en attendant la phase de lecture.

Une phase de lecture RP d'un signal représentatif des charges au noeud MEM est réalisée pour chaque pixel Pix ligne après ligne. A titre d'exemple, on a illustré en figure 3 la lecture des potentiels aux noeuds MEM de pixels de deux lignes de pixels adjacentes de rang n et n+1.

A l'instant t₄, le transistor T_{RS} est mis à l'état passant pour chaque pixel de la ligne de rang n, ce qui débute la phase de lecture des pixels de la ligne de rang n. Le transistor T_{R} forme un suiveur de tension réalisant la conversion du potentiel au noeud SN en une tension qui se retrouve à la source du transistor T_{R}.

A l'instant t₅, le transistor T_{RST} est mis à l'état passant pour chaque pixel Pix de la ligne de rang n. Ceci permet de réinitialiser le noeud SN, la tension au noeud SN étant alors mise à VDD. Le potentiel au noeud SN est représentatif de la quantité de charges stockées dans la photodiode PH.

A l'instant t₆, le transistor T_{RST} est mis à l'état non passant pour chaque pixel Pix de la ligne de rang n. Ceci fige le potentiel au noeud SN. Le niveau de la tension OUT V PIX suit le potentiel au noeud SN. Une première lecture de la tension OUT_V_PIX est alors réalisée par le circuit de lecture 8.

A l'instant t₇, le transistor T_{TG2} est mis à l'état passant pour chaque pixel Pix de la ligne de rang n. Ceci entraîne un transfert de charges du noeud MEM au noeud SN.

A l'instant tg, le transistor T_{TG2} est mis à l'état non passant pour chaque pixel Pix de la ligne de rang n. Ceci fige le niveau du potentiel du noeud SN. Le niveau de la tension OUT V PIX suit le potentiel au noeud SN. Une deuxième lecture de la tension OUT_V_PIX est alors réalisée par le circuit de lecture 8.

A l'instant t₉, le transistor T_{RS} est mis à l'état non passant pour chaque pixel de la ligne de rang n, ce qui finit la phase de lecture des pixels de la ligne de rang n.

La même séquence d'évolution des signaux RS, RST et TG2 est ensuite réalisée pour les pixels Pix de la ligne de rang n+1.

Un signal représentatif de la quantité de charges stockées dans la photodiode PH est obtenu en déterminant la différence entre les première et deuxième lectures de la tension OUT_V_PIX. Le niveau de bruit de réinitialisation (ou bruit kTC) au noeud SN étant le même aux première et deuxième lectures, il est supprimé lors de la détermination du signal différentiel. Un faible niveau de bruit du signal différentiel peut être obtenu.

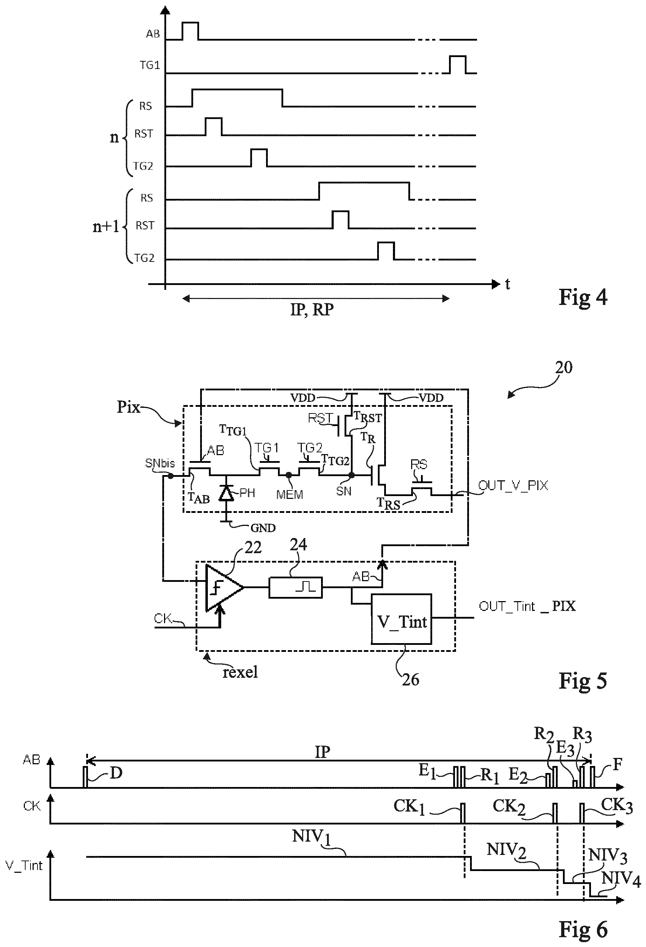

La figure 4 est un chronogramme illustrant un mode de réalisation d'un procédé de fonctionnement du capteur d'images 5 du type IWR. Le chronogramme représenté en figure 4 est identique à celui représenté en figure 3 à la différence que la phase de lecture RP des noeuds SN des pixels du capteur d'images est réalisée au moins en partie simultanément avec la phase d'intégration IP des pixels du capteur d'images 5. Les potentiels aux noeuds SN qui sont lus pendant la phase de lecture RP sont ceux obtenus à la fin de la phase d'intégration précédente. La vitesse du capteur d'images mettant en oeuvre un procédé de lecture IWR tel qu'illustré par le chronogramme de la figure 4 est supérieure à celle du capteur d'images mettant en oeuvre le procédé de lecture illustré par le chronogramme de la figure 3.

La figure 5 est un schéma électrique d'un mode de réalisation d'un capteur d'images 20 mettant en oeuvre un procédé d'extension de dynamique. Le capteur 20 comprend l'ensemble des éléments du capteur d'images 5 représenté en figure 2 et comprend en outre, pour chaque pixel Pix, un circuit rexel de détection d'un débordement du pixel Pix. Selon un autre mode de réalisation, le capteur d'images 20 peut ne comprendre un circuit rexel que pour certains des pixels Pix. Selon un autre mode de réalisation, le circuit rexel peut être relié à plusieurs pixels Pix.

Bien que le pixel Pix représenté en figure 5 soit du type "6T", la structure du pixel Pix peut être différente. Selon un autre mode de réalisation, le transistor T_{TG1} n'est pas présent. Toutefois, un inconvénient d'un tel pixel est qu'il ne permet pas la réalisation d'une lecture différentielle. Selon un autre mode de réalisation, la conversion des charges stockées au noeud SN en tension OUT_V_PIX peut être réalisée par d'autres moyens que ceux représentés en figure 2. A titre d'exemple, le principe de lecture illustré en figure 3 du document US 2013/119233 peut être mis en oeuvre.

Le circuit rexel est adapté à détecter un éventuel débordement des charges stockées dans la photodiode PH par l'intermédiaire du transistor T_{AB}.

Selon un mode de réalisation, le circuit rexel comprend un circuit de comparaison 22 commandé par un signal CK et dont une entrée est reliée à un noeud SNbis lui-même relié au drain du transistor T_{AB}. La sortie du circuit de comparaison 22 est reliée à un circuit 24 fournissant le signal de commande AB. La sortie du circuit de comparaison 22 est en outre reliée à un circuit 26 de fourniture d'un signal OUT_Tint_PIX représentatif de la durée d'intégration effective du pixel Pix. Selon un mode de réalisation, le signal OUT_Tint_PIX est un signal numérique. Selon un autre mode de réalisation, le signal OUT_Tint_PIX est un signal analogique fourni par le circuit 26 à partir du signal discret V_Tint.

La figure 6 est un chronogramme de signaux de commande selon un mode de réalisation d'un procédé de fonctionnement du capteur d'images 20 représenté en figure 5.

Pendant une phase d'intégration IP du pixel Pix, délimitée par les impulsions D et F du signal AB, plusieurs impulsions du signal AB sont réalisées pour détecter si la quantité de charges collectées par la photodiode PH serait proche de la limite de saturation de la photodiode PH à la fin de la phase d'intégration si le présent mode de réalisation du procédé de fonctionnement du capteur d'images 20 n'était pas mis en oeuvre. De telles impulsions sont appelées impulsions de détection par la suite, trois impulsions de détection E₁, E₂, E₃ sont représentées en figure 6. Chaque impulsion de détection E₁, E₂, E₃ du signal AB est suivie d'une impulsion CK₁, CK₂, CK₃ du signal CK. Chaque impulsion de détection E₁, E₂, E₃ du signal AB rend passant au moins partiellement le transistor T_{AB} et peut entraîner un transfert de charges de la photodiode PH au noeud SNbis, et donc une variation du potentiel du noeud SNbis. La quantité de charges transférées dépend du niveau de l'impulsion de détection et de la quantité de charges collectées par la photodiode PH. La quantité de charges transférées vers le noeud SNbis est représentative d'un "excès" de charges collectées par la photodiode PH, c'est-à-dire représentative du fait que la photodiode PH serait proche de la limite de saturation à la fin de la phase d'intégration si le présent mode de réalisation du procédé de fonctionnement du capteur d'images 20 n'était pas mis en oeuvre.

Le potentiel au noeud SNbis est comparé, de façon directe ou indirecte, à un seuil par le circuit de comparaison 22. En fonction du résultat de la comparaison, la sortie du circuit de comparaison 22 peut basculer pendant l'impulsion CK₁, CK₂, CK₃ si un excès de charges collectées par la photodiode PH est détecté. Un basculement de la sortie du circuit de comparaison 22 entraîne l'application d'une impulsion R₁, R₂, R₃ du signal AB pour réinitialiser la photodiode PH, appelées impulsions de réinitialisation par la suite. En figure 6, on a représenté trois impulsions de réinitialisation R₁, R₂, R₃ du signal AB, ce qui signifie que le pixel Pix est réinitialisé trois fois en plus de la réinitialisation ayant eu lieu au début de la phase d'intégration. Ceci peut être obtenu dans le cas où le pixel Pix est exposé à un rayonnement de forte intensité. Dans le cas où le pixel Pix est exposé à un rayonnement d'intensité moindre, le signal AB peut ne présenter qu'une impulsion ou deux impulsions parmi les impulsions R₁, R₂, R₃ voire aucune des impulsions R₁, R₂, R₃. A chaque impulsion de réinitialisation R₁, R₂, R₃ du signal AB, le circuit 26 fournit un signal OUT_Tint_PIX représentatif de la durée d'intégration effective de la photodiode PH depuis la dernière réinitialisation du pixel. Dans le cas où le circuit 26 fournit le signal OUT_Tint_PIX à partir du signal V_Tint, le signal V_Tint peut être une tension discrète dont le niveau varie peu après la fin de chaque impulsion CK₁, CK₂ et CK₃, chaque niveau du signal V_Tint étant représentatif de l'instant de survenue d'une impulsion du signal CK. On a représenté quatre niveaux NIV₁, NIV₂, NIV₃, NIV₄ décroissants successivement du signal V_Tint en figure 6.

Une opération de lecture comprend alors la lecture du signal OUT_V_PIX, par exemple selon les procédés de lecture décrits précédemment en relation avec les figures 3 ou 4, et la lecture du signal OUT_Tint_PIX. La quantité totale de charges collectées par la photodiode pendant la phase d'intégration peut alors être déterminée à partir des signaux OUT_V_PIX et OUT_Tint_PIX.

Le nombre d'impulsions de détection E₁, E₂, E₃ du signal AB pendant chaque phase d'intégration IP peut varier de deux à 10.

De préférence, au cours d'une phase d'intégration IP, les impulsions de détection E₁, E₂, E₃ ne sont pas réparties de façon régulière pendant la phase d'intégration IP. De préférence, au cours d'une phase d'intégration IP, la durée entre deux impulsions de détection diminue au fur et à mesure du déroulement de la phase d'intégration. Un nombre plus important de détections est donc réalisé en fin de phase d'intégration, là où le risque que la photodiode parvienne à saturation est plus élevé. Selon un mode de réalisation, en considérant successivement chaque impulsion de détection depuis la dernière impulsion de détection jusqu'à la première impulsion de détection, la durée entre l'impulsion de détection et l'impulsion de fin F suit une progression géométrique.

Selon un mode de réalisation, les niveaux des impulsions de détection E₁, E₂, E₃ du signal AB ne sont pas identiques pour chaque impulsion de détection. Selon un mode de réalisation, au cours d'une phase d'intégration, le niveau de chaque impulsion de détection E₁, E₂, E₃ diminue au fur et à mesure du déroulement de la phase d'intégration. De ce fait, le transistor T_{AB} sera moins passant à la deuxième impulsion de détection E₂ qu'à la première impulsion de détection E₁ et ainsi de suite et des charges ne seront transférées, à la deuxième impulsion de détection E₂, vers le noeud SNbis depuis la photodiode PH que dans un cas où la photodiode PH est plus proche de la saturation que pour la première impulsion de détection E₁. Ceci permet d'éviter des détections positives aux impulsions de détection qui suivent la première impulsion alors que l'intensité du signal lumineux atteignant le pixel est suffisamment faible pour ne pas entraîner de justesse de détection positive à la première impulsion de détection.

Selon un autre mode de réalisation, les niveaux des impulsions de détection E₁, E₂, E₃ du signal AB sont sensiblement identiques pour chaque impulsion de détection. Le circuit rexel peut alors comprendre un circuit adapté à empêcher la survenue de l'impulsion de réinitialisation R₂, et éventuellement des impulsions de réinitialisation ultérieures, dans le cas où il n'y a pas eu de première impulsion de réinitialisation R₁.

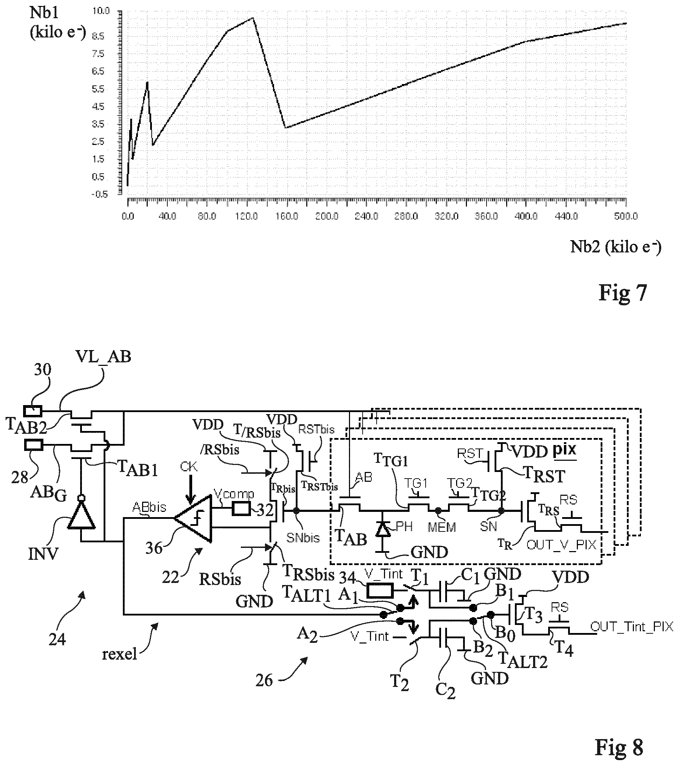

La figure 7 est une courbe d'évolution, obtenue par simulation, pour le pixel représenté en figure 5, du nombre Nb1 d'électrons (exprimé en kilo électrons) reçus au noeud de lecture SN à la fin de la phase d'intégration en fonction du nombre total Nb2 d'électrons (exprimé en kilo électrons) reçus par la photodiode PH au cours de la phase d'intégration.

Cette simulation a été obtenue en considérant les paramètres suivants :
- photodiode PH saturant à 9000 électrons ;
- durée entre les impulsions D et F de 2,16 ms ;
- trois impulsions de détection espacées de l'impulsion F respectivement de 360 µs, 60 µs et 10 µs.

En figure 7, chaque diminution brusque de la courbe signifie qu'une réinitialisation du pixel a été réalisée.

En l'absence de mise en oeuvre du procédé d'extension de dynamique, la dynamique du pixel est d'environ 9000 électrons. Lorsque le procédé d'extension de dynamique est mis en oeuvre, la dynamique obtenue est d'environ 450000 électrons, soit une augmentation de plus de 34 dB. En outre, le rapport signal à bruit reste supérieur à 28 dB lorsque le procédé d'extension de dynamique est mis en oeuvre.

Selon un mode de réalisation, le capteur d'images 20 peut mettre en oeuvre un procédé d'acquisition d'images du type Global Shutter, c'est-à-dire un procédé de commande des pixels dans lequel les débuts et fins des phases d'intégration des pixels sont simultanés. Dans le cas d'un procédé d'acquisition d'images du type Global Shutter dans lequel les impulsions D et F du signal AB sont sensiblement simultanées pour toutes les lignes du capteur d'images 20, il peut être avantageux que les signaux CK soient légèrement décalés d'une ligne à l'autre, de façon à lisser la consommation du capteur d'images et éviter la génération de pics de consommation.

Selon un autre mode de réalisation, le procédé d'acquisition d'images peut être du type à "obturateur déroulant" (en anglais Rolling Shutter) dans lequel les phases d'intégration des lignes de pixels sont décalées dans le temps les unes par rapport aux autres. Un procédé d'acquisition d'images du type Rolling Shutter peut être mis en oeuvre notamment avec la structure de pixel "6T" représentée en figure 5.

Le capteur d'images 20 peut être réalisé selon une technologie dite tridimensionnelle, par exemple telle que décrite dans le brevet FR 2 970 598. Le capteur d'images 20 comprend alors un empilement d'au moins deux couches de silicium superposées. Les pixels peuvent être réalisés en totalité ou en partie dans la première couche de silicium et les circuits rexel peuvent être réalisés en totalité ou en partie dans la deuxième couche de silicium.

La figure 8 est un schéma électrique d'un mode de réalisation plus détaillé du capteur d'images 20. Selon un mode de réalisation, le circuit rexel est commun à plusieurs pixels, quatre à titre d'exemple en figure 8. Les transistors T_{AB} de ces quatre pixels Pix peuvent être reliés au noeud SNbis. Dans ce cas, il est observé la somme des débordements des quatre pixels. A titre de variante, seul le transistor T_{AB} de l'un des quatre pixels Pix, appelé pixel réfèrent, est relié au noeud SNbis. Dans ce cas, seul le débordement du pixel référent est observé. Toutefois, les quatre pixels Pix peuvent être réinitialisés à chaque fois que le débordement du pixel référent est détecté.

Le capteur d'images 20 comprend une source 28 d'un signal discret AB_{G}, par exemple une tension, qui peut prendre plusieurs valeurs constantes et une source 30 d'un signal constant VL_AB, égal au niveau bas du signal AB.

Le capteur d'images 20 comprend en outre une source 32 d'un signal de comparaison Vcomp constant, par exemple une tension constante. Le capteur d'images 20 comprend en outre une source 34 d'un signal discret V_Tint, par exemple une tension, qui peut prendre plusieurs valeurs constantes.

Chaque circuit rexel comprend un transistor MOS T_{RSTbis} dont le drain est relié à la source du potentiel de référence haut VDD, dont la source est reliée au noeud SNbis et dont la grille reçoit le signal RSTbis.

Le circuit de comparaison 22 comprend :
un transistor MOS T_{Rbis} dont la grille est reliée au noeud SNbis ;
un interrupteur T_{RSbis} qui relie la source du transistor T_{Rbis} à la source du potentiel de référence bas GND et qui est commandé par un signal de commande RSbis ;
un interrupteur T_{/RSbis} qui relie le drain du transistor T_{Rbis} à la source du potentiel de référence haut VDD et qui est commandé par un signal de commande /RSbis ; et
un comparateur 36 commandé par le signal CK recevant à une première entrée le signal à la source du transistor T_{Rbis}, recevant à une deuxième entrée un signal de comparaison Vcomp et dont la sortie fournit le signal ABbis, par exemple un signal binaire.

Le signal /RSbis peut correspondre au complément du signal RSbis. De façon générale, les signaux /RSbis et RSbis sont tels que les transistors T_{RSbis} et T_{/RSbis} ne sont pas passants simultanément.

Selon un mode de réalisation, lorsque le signal CK est à un premier niveau, par exemple au niveau bas, le signal ABbis fourni par le comparateur 36 est indépendant des signaux aux entrées du comparateur 36 et est par exemple au niveau bas. Lorsque le signal CK passe du premier niveau à un deuxième niveau, par exemple lors d'un front montant du niveau bas au niveau haut, le signal ABbis fourni par le comparateur 36 dépend de la comparaison des signaux en entrée du comparateur 36, et est, par exemple, à l'état bas lorsque la tension à la source du transistor T_{Rbis} est supérieure à la tension Vcomp et est à l'état haut lorsque la tension à la source du transistor T_{Rbis} est inférieure à la tension Vcomp. La valeur du signal ABbis au front du signal CK du premier niveau au deuxième niveau est maintenue tant que le signal CK est au deuxième niveau.

Selon le présent mode de réalisation, le circuit 24 fournissant le signal de commande AB comprend :
un inverseur INV dont l'entrée est reliée à la sortie du comparateur 36 ;
un transistor MOS T_{AB1} dont l'une des bornes de commande (source ou drain) est reliée à la source 28 du signal discret AB_{G}, dont l'autre borne de commande est reliée à la grille du transistor T_{AB} de chaque pixel Pix associé au circuit rexel et dont la grille est reliée à la sortie de l'inverseur INV ; et
un transistor MOS T_{AB2} dont l'une des bornes de commande (source ou drain) est reliée à la source 30 du signal binaire VL_AB, dont l'autre borne de commande est reliée à la grille du transistor T_{AB} de chaque pixel Pix associé au circuit rexel et dont la grille est reliée à la sortie du comparateur 36.

Selon le présent mode de réalisation, le circuit 26 de fourniture du signal OUT_Tint_PIX comprend :
un interrupteur T_{ALT1} reliant alternativement la sortie du comparateur 36 à un noeud A₁ ou un noeud A₂ ;
un interrupteur T₁ commandé par le signal au noeud A₁ et reliant la source 34 du signal V_Tint à une première électrode d'un condensateur C₁ dont la seconde électrode est reliée à la source du potentiel bas GND ;
un interrupteur T₂ commandé par le signal au noeud A₂ et reliant la source 34 du signal V_Tint à une première électrode d'un condensateur C₂ dont la seconde électrode est reliée à la source du potentiel bas GND ;
un interrupteur T_{ALT2} reliant alternativement un noeud B₀ à un noeud B₁ relié à la première électrode du condensateur C₁ ou à un noeud B₂ relié à la première électrode du condensateur C₂, l'interrupteur T_{ALT2} étant relié au noeud B₂ lorsque l'interrupteur T_{ALT1} est relié au noeud A₁ et l'interrupteur T_{ALT2} étant relié au noeud B₁ lorsque l'interrupteur T_{ALT1} est relié au noeud A₂ ;
un transistor MOS T₃, par exemple à canal N, monté en suiveur, dont le drain est relié à la source du potentiel de référence haut VDD et dont la grille est reliée au noeud B₀ ; et
un transistor MOS T₄, par exemple à canal N, dont le drain est relié à la source du transistor T₃, dont la source fournit le signal OUT_Tint_PIX et dont la grille reçoit le signal RS.

Un mode de réalisation d'un procédé de fonctionnement du capteur d'images 20 représenté en figure 8 va maintenant être décrit. Le fonctionnement du capteur d'images 20 est identique à ce qui a été décrit précédemment en relation avec le chronogramme de la figure 6.

En dehors des impulsions du signal CK, le signal ABbis est maintenu au niveau bas de sorte que le transistor T_{AB1} est rendu passant et le transistor T_{AB2} est rendu non passant. Le signal AB est alors égal au signal AB_{G}. A titre d'exemple, les positions des interrupteurs T_{ALT1} et T_{ALT2} alternent à chaque phase d'intégration. A titre d'exemple, à une phase d'intégration, l'interrupteur T_{ALT1} est relié au noeud A₁ et l'interrupteur T_{ALT2} est relié au noeud B₂ et, à la phase d'intégration suivante, l'interrupteur T_{ALT1} est relié au noeud A₂ et l'interrupteur T_{ALT2} est relié au noeud B₁.

A titre d'exemple, chaque interrupteur T₁ et T₂ est passant lorsque le signal qui le commande est à l'état bas pendant une impulsion du signal CK et est non passant lorsque le signal qui le commande est à l'état haut pendant une impulsion du signal CK. En dehors des impulsions du signal CK, les interrupteurs T₁ et T₂ sont non passants.

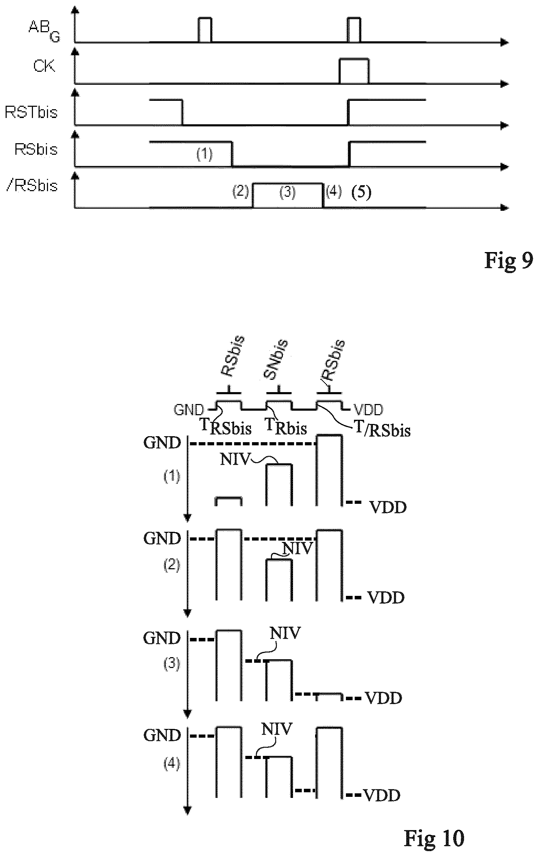

La figure 9 est un chronogramme de signaux de commande du capteur d'images 20 représenté en figure 8 au niveau d'une impulsion de détection E₁ du signal AB_{G} et de l'impulsion CK₁ qui suit du signal CK. La figure 10 illustre l'évolution des niveaux de potentiel aux régions de drain, de source et de canal des transistors T_{RSbis}, T_{Rbis} et T_{/RSbis}.

Avant une impulsion de détection E₁ du signal AB_{G}, le signal RSTbis qui était à l'état haut passe à l'état bas de sorte que le transistor T_{RSTbis} est non passant. Pendant l'impulsion de détection E₁ du signal AB_{G}, le signal RSbis est à l'état haut et le signal /RSbis est à l'état bas. Ceci correspond à la configuration (1) des potentiels en figure 10. Le potentiel au noeud SNbis est à un niveau NIV qui dépend de la quantité de charges ayant passé de la photodiode PH au noeud SNbis. A la fin de l'impulsion de détection E₁, le potentiel au noeud SNbis ne varie sensiblement pas. Après l'impulsion de détection E₁, le signal RSbis passe au niveau bas, ce qui correspond à la configuration (2) des potentiels en figure 10, puis le signal /RSbis passe au niveau haut, ce qui correspond à la configuration (3) des potentiels en figure 10. Le potentiel à la source du transistor T_{Rbis} varie jusqu'au niveau NIV pour suivre le potentiel au noeud SNbis. Le signal /RSbis repasse alors au niveau haut, ce qui correspond à la configuration (4) des potentiels en figure 10. Le potentiel à la source du transistor T_{Rbis} ne varie sensiblement pas.

L'impulsion CK₁ se produit alors. Selon le résultat de la comparaison entre le signal Vcomp et le potentiel à la source du transistor T_{Rbis} au front montant de l'impulsion CK₁, la sortie du comparateur 26 reste au niveau bas ou bascule au niveau haut et le signal AB est égal au signal AB_{G} ou au signal VL_AB. Peu après le front montant de l'impulsion CK₁, le signal RSTbis passe à l'état haut et le signal RSbis passe à l'état haut. Ceci n'entraîne toutefois pas de changement de la sortie du comparateur 36 qui reste bloquée pendant toute l'impulsion CK₁.

L'impulsion de réinitialisation R₁ se produit alors pour le signal AB_{G}. Selon la sortie du comparateur 36, cette impulsion de réinitialisation R₁ est transmise ou non au signal AB selon le résultat de la comparaison entre le signal Vcomp et le potentiel à la source du transistor T_{Rbis}. Lorsque l'impulsion est transmise au signal AB, le transistor T_{AB} est rendu au moins partiellement passant de sorte que la photodiode PH est vidée de ses charges par l'intermédiaire de la source du potentiel de référence haut VDD et est réinitialisée.

Le présent mode de réalisation de détection du "débordement" de la photodiode PH qui met en oeuvre le transistor T_{Rbis} et les interrupteurs T_{RSbis} et T_{/RSbis} présentent l'avantage d'une faible consommation puisque la modification du potentiel à l'une des entrées du comparateur 36 est obtenue sans circulation de courant utilisant une source de courant.

Des modes de réalisation particuliers de la présente invention ont été décrits. Diverses variantes et modifications apparaîtront à l'homme de l'art.

## Revendications

1. Capteur d'images (20) comprenant des pixels (Pix), chaque pixel comprenant un photodétecteur (PH) et un circuit de lecture de la quantité de charges collectées par le photodétecteur à la fin d'une phase (IP) de collecte de charges par le photodétecteur, le capteur d'images comprenant en outre, pour au moins l'un des pixels, un circuit de détection (rexel) adapté, au moins à chacun de deux instants différents pendant ladite phase, à détecter si la quantité de charges collectées audit instant par le photodétecteur dudit pixel dépasse un seuil et, dans le cas où ladite quantité de charges collectées audit instant dépasse le seuil, à mémoriser un premier signal représentatif (OUT_Tint_PIX) dudit instant et à réinitialiser le photodétecteur, dans lequel, pour chaque pixel (Pix), le circuit de lecture comprend au moins un premier transistor (T_{G1}) reliant le photodétecteur (PH) à un premier noeud (SN) et dans lequel chaque pixel (Pix) comprend, en outre, un deuxième transistor (T_{AB}) reliant le photodétecteur à un deuxième noeud (SNbis), ledit deuxième noeud d'au moins l'un des pixels étant relié au circuit de détection (rexel).

2. Capteur d'images (20) selon la revendication 1, comprenant, en outre, un troisième transistor (T_{RSTbis}) reliant le deuxième noeud (SNbis) à une source d'un premier potentiel de référence (VDD).

3. Capteur d'images (20) selon la revendication 2, dans lequel le circuit de détection (rexel) est adapté, pour chacun desdits instants, à rendre au moins partiellement passant le deuxième transistor (T_{AB}), le troisième transistor étant alors non passant, puis à rendre passants le deuxième transistor (T_{AB}) et le troisième transistor dans le cas où la quantité de charges collectées audit instant dépasse ledit seuil.

4. Capteur d'images (20) selon l'une quelconque des revendications 1 à 3, comprenant un comparateur (36) et un circuit (24) de commande du deuxième transistor (T_{AB}) à partir du signal (ABbis) fourni par le comparateur.

5. Capteur d'images (20) selon l'une quelconque des revendications 1 à 4, comprenant une première source (28) d'un premier signal discret (AB_{G}) de plusieurs premiers niveaux et dans lequel le circuit de détection (rexel) est adapté à commander le deuxième transistor (T_{AB}) avec l'un desdits premiers niveaux en fonction dudit instant.

6. Capteur d'images (20) selon l'une quelconque des revendications 1 à 5, dans lequel le circuit de détection (rexel) comprend un circuit de mémorisation du premier signal représentatif (OUT Tint PIX) dudit instant, dans le cas où la quantité de charges collectées audit instant dépasse ledit seuil, le premier signal étant un signal analogique ou un signal numérique.

7. Capteur d'images (20) selon la revendication 6, dans lequel le circuit de mémorisation comprend une deuxième source (28) d'un deuxième signal discret (V Tint) de plusieurs deuxièmes niveaux, au moins un condensateur (C₁) et un circuit de charge du condensateur avec l'un desdits deuxièmes niveaux en fonction dudit instant, dans le cas où la quantité de charges collectées audit instant dépasse ledit seuil.

8. Capteur d'images (20) selon l'une quelconque des revendications 1 à 7, dans lequel, pour chaque pixel (Pix), le circuit de lecture comprend un quatrième transistor MOS (T_{R}) dont la grille est reliée au premier noeud (SN) et dans lequel le circuit de détection (rexel) comprend un cinquième transistor MOS (T_{Rbis}) dont la grille est reliée au deuxième noeud (SNbis).

9. Capteur d'images (20) selon la revendication 8 dans son rattachement à la revendication 2, dans lequel le circuit de détection (rexel) comprend un premier interrupteur (T_{/RSbis}) reliant l'une des bornes entre la source et le drain du cinquième transistor MOS (T_{Rbis}) à la source du premier potentiel de référence (VDD) et un deuxième interrupteur (T_{RSbis}) reliant l'autre borne entre la source et le drain du cinquième transistor MOS (T_{Rbis}) à une source d'un deuxième potentiel de référence (GND).

10. Procédé d'acquisition d'images par un capteur d'images (20) comprenant des pixels (Pix), chaque pixel comprenant un photodétecteur (PH) et un circuit de lecture de la quantité de charges collectées par le photodétecteur à la fin d'une phase (IP) de collecte de charges par le photodétecteur, le procédé comprenant les étapes suivantes réalisées pour au moins l'un des pixels :
a) détecter, au moins à chacun de deux instants différents pendant ladite phase, si la quantité de charges collectées audit instant par le photodétecteur dudit pixel dépasse un seuil ; et
b) dans le cas où la quantité de charges collectées audit instant par le photodétecteur dépasse le seuil, mémoriser un premier signal représentatif (OUT_Tint_PIX) dudit instant et réinitialiser le photodétecteur, dans lequel, pour chaque pixel (Pix), le circuit de lecture comprend au moins un premier transistor (T_{G1}) reliant le photodétecteur (PH) à un premier noeud (SN), dans lequel chaque pixel (Pix) comprend, en outre, un deuxième transistor (T_{AB}) reliant le photodétecteur à un deuxième noeud (SNbis), ledit deuxième noeud d'au moins l'un des pixels étant relié au circuit de détection (rexel).

11. Procédé selon la revendication 10, dans lequel, à l'étape a), à chacun desdits instants, le deuxième transistor est rendu au moins partiellement passant, le premier transistor étant non passant, et dans lequel, à l'étape b), dans le cas où la quantité de charges collectées audit instant dépasse ledit seuil, le deuxième transistor est rendu passant pour réinitialiser le photodétecteur.

## Patentansprüche

1. Bildsensor (20) mit Pixeln (Pix), wobei jedes Pixel einen Fotodetektor (PH) und eine Schaltung zum Auslesen der Menge der durch den Fotodetektor am Ende einer Ladungserfassungsphase (IP) der durch den Fotodetektor gesammelten Ladungen aufweist, wobei der Bildsensor ferner für wenigstens eines der Pixel eine Detektionsschaltung (rexel) aufweist, die wenigstens zu jedem von zwei verschiedenen Zeitpunkten während der Phase in der Lage ist, zu detektieren, ob die Menge der zu diesem Zeitpunkt durch den Fotodetektor des Pixels erfassten Ladungen einen Schwellenwert überschreitet, und, in dem Fall, dass die Menge der zu diesem Zeitpunkt gesammelten Ladungen den Schwellenwert überschreitet, ein erstes Signal (OUT_Tint_PIX), das für diesen Zeitpunkt repräsentativ ist, zu speichern und den Fotodetektor zurückzusetzen, wobei die Ausleseschaltung für jedes Pixel (Pix) wenigstens einen ersten Transistor (T_{G1}) aufweist, der den Fotodetektor (PH) mit einem ersten Knoten (SN) koppelt, und wobei jedes Pixel (Pix) ferner einen zweiten Transistor (T_{AB}) aufweist, der den Fotodetektor mit einem zweiten Knoten (SNbis) koppelt, wobei der zweite Knoten von wenigstens einem der Pixel mit der Detektionsschaltung (Rexel) gekoppelt ist.

2. Bildsensor (20) nach Anspruch 1, der ferner einen dritten Transistor (T_{RSTbis}) aufweist, der den zweiten Knoten (SNbis) mit einer Quelle eines ersten Referenzpotentials (VDD) koppelt.

3. Bildsensor (20) nach Anspruch 2, wobei die Detektionsschaltung (Rexel) in der Lage ist, für jeden der Zeitpunkte den zweiten Transistor (T_{AB}) wenigstens teilweise leitend zu machen, wobei der dritte Transistor dann nicht leitend ist, und den zweiten Transistor (T_{AB}) und den dritten Transistor in dem Fall leitend zu machen, wenn die Menge der zu diesem Zeitpunkt gesammelten Ladungen den Schwellenwert übersteigt.

4. Bildsensor (20) nach einem der Ansprüche 1 bis 3, mit einem Komparator (36) und einer Schaltung (24) zum Steuern des zweiten Transistors (T_{AB}) über ein vom Komparator geliefertes Signal (ABbis).

5. Bildsensor (20) nach einem der Ansprüche 1 bis 4, der eine erste Quelle (28) eines ersten diskreten Signals (AB_{G}) mit einer Vielzahl von ersten Pegeln aufweist und wobei die Detektionsschaltung (Rexel) in der Lage ist, den zweiten Transistor (T_{AB}) mit einem der ersten Pegel als Funktion des Zeitpunkts zu steuern.

6. Bildsensor (20) nach einem der Ansprüche 1 bis 5, wobei die Detektionsschaltung (Rexel) eine Schaltung zum Speichern des ersten Signals (OUT_Tint_PIX) aufweist, das für den Zeitpunkt repräsentativ ist, und zwar für den Fall, dass die Menge der zu diesem Zeitpunkt gesammelten Ladungen den genannten Schwellenwert überschreitet, wobei das erste Signal ein analoges Signal oder ein digitales Signal ist.

7. Bildsensor (20) nach Anspruch 6, wobei die Speicherschaltung Folgendes aufweist: eine zweite Quelle (28) eines zweiten diskreten Signals (V_Tint) mit einer Vielzahl von zweiten Pegeln, wenigstens einen Kondensator (C₁) und eine Schaltung zum Aufladen des Kondensators mit einem der zweiten Pegel als Funktion des Zeitpunkt, und zwar für den Fall, dass die Menge der zu diesem Zeitpunkt gesammelten Ladungen den genannten Schwellenwert überschreitet.

8. Bildsensor (20) nach einem der Ansprüche 1 bis 7, wobei für jedes Pixel (Pix) die Ausleseschaltung einen vierten MOS-Transistor (T_{R}) aufweist, dessen Gate mit dem ersten Knoten (SN) gekoppelt ist, und wobei die Detektionsschaltung (Rexel) einen fünften MOS-Transistor (T_{Rbis}) aufweist, dessen Gate mit dem zweiten Knoten (SNbis) gekoppelt ist.

9. Bildsensor (20) nach Anspruch 8 und Anspruch 2, wobei die Detektionsschaltung (Rexel) einen ersten Schalter (T_{/RSbis}) aufweist, der einen der Anschlüsse zwischen der Source und dem Drain des fünften MOS-Transistors (T_{Rbis}) mit der Quelle des ersten Referenzpotentials (VDD) verbindet, sowie einen zweiten Schalter (T_{RSbis}), der den anderen Anschluss zwischen der Source und dem Drain des fünften MOS-Transistors (T_{Rbis}) mit einer Quelle eines zweiten Referenzpotentials (GND) verbindet.

10. Verfahren zur Bilderfassung durch einen Bildsensor (20), der Pixel (Pix) aufweist, wobei jedes Pixel einen Fotodetektor (PH) und eine Schaltung zum Auslesen der Menge an Ladungen aufweist, die vom Fotodetektor am Ende einer Ladungserfassungsphase (IP) durch den Fotodetektor gesammelt wurden, wobei das Verfahren die folgenden Schritte aufweist, die für wenigstens eines der Pixel ausgeführt werden:
a) Detektieren, wenigstens zu jedem von zwei verschiedenen Zeitpunkten während der Phase, ob die Menge der zu diesem Zeitpunkt durch den Fotodetektor des Pixels gesammelten Ladungen einen Schwellenwert überschreitet; und
b) in dem Fall, dass die Menge der zu diesem Zeitpunkt vom Fotodetektor gesammelten Ladungen den Schwellenwert überschreitet, Speichern eines ersten Signals (OUT_Tint_PIX), das für diesen Zeitpunkt repräsentativ ist, und Rücksetzten des Fotodetektors, wobei für jedes Pixel (Pix) die Ausleseschaltung wenigstens einen ersten Transistor (T_{G1}) aufweist, der den Fotodetektor (PH) mit einem ersten Knoten (SN) koppelt, wobei jedes Pixel (Pix) ferner einen zweiten Transistor (T_{AB}) aufweist, der den Fotodetektor mit einem zweiten Knoten (SNbis) koppelt, wobei der zweite Knoten von wenigstens einem der Pixel mit der Detektionsschaltung (Rexel) gekoppelt ist.

11. Verfahren nach Anspruch 10, wobei in Schritt a) zu jedem der genannten Zeitpunkte der zweite Transistor wenigstens teilweise leitend gemacht wird, wobei der erste Transistor nicht leitend ist, und wobei in Schritt b) in dem Fall, dass die Menge der zu diesem Zeitpunkt gesammelten Ladungen den genannten Schwellenwert übersteigt, der zweite Transistor leitend gemacht wird, um den Fotodetektor zurückzusetzen.

## Claims

1. An image sensor (20) comprising pixels (Pix), each pixel comprising a photodetector (PH) and a circuit for reading out the quantity of charges collected by the photodetector at the end of a phase (IP) of charge collection by the photodetector, the image sensor further comprising, for at least one of the pixels, a detection circuit (rexel) capable, at least at each of two different times during said phase, of detecting whether the quantity of charges collected at said time by the photodetector of said pixel exceeds a threshold and, in the case where said quantity of charges collected at said time exceeds the threshold, of storing a first signal (OUT_Tint_PIX) representative of said time and of resetting the photodetector, wherein, for each pixel (Pix), the readout circuit comprises at least one first transistor (T_{G1}) coupling the photodetector (PH) to a first node (SN) and wherein each pixel (Pix) further comprises a second transistor (T_{AB}) coupling the photodetector to a second node (SNbis), said second node of at least one of the pixels being coupled to the detection circuit (rexel).

2. The image sensor (20) of claim 1, further comprising a third transistor (T_{RSTbis}) coupling the second node (SNbis) to a source of a first reference potential (VDD).

3. The image sensor (20) of claim 2, wherein the detection circuit (rexel) is capable, for each of said times, of making the second transistor (T_{AB}) at least partially conductive, the third transistor being then non-conductive, and then of making the second transistor (T_{AB}) and the third transistor conductive in the case where the quantity of charges collected at said time exceeds said threshold.

4. The image sensor (20) of any of claims 1 to 3, comprising a comparator (36) and a circuit (24) for controlling the second transistor (T_{AB}) from the signal (ABbis) supplied by the comparator.

5. The image sensor (20) of any of claims 1 to 4, comprising a first source (28) of a first discrete signal (AB_{G}) having a plurality of first levels and wherein the detection circuit (rexel) is capable of controlling the second transistor (T_{AB}) with one of said first levels according to said time.

6. The image sensor (20) of any of claims 1 to 5, wherein the detection circuit (rexel) comprises a circuit for storing the first signal (OUT_Tint_PIX) representative of said time, in the case where the quantity of charges collected at said time exceeds said threshold, the first signal being an analog signal or a digital signal.

7. The image sensor (20) of claim 6, wherein the storage circuit comprises a second source (28) of a second discrete signal (V_Tint) having a plurality of second levels, at least a capacitor (C₁) and a circuit for charging the capacitor with one of said second levels according to said time, in which case the quantity of charges collected at said time exceeds said threshold.

8. The image sensor (20) of any of claims 1 to 7, wherein, for each pixel (Pix), the readout circuit comprises a fourth MOS transistor (T_{R}) having its gate coupled to the first node (SN) and wherein the detection circuit (rexel) comprises a fifth MOS transistor (T_{Rbis}) having its gate coupled to the second node (SNbis).

9. The image sensor (20) of claim 8 and of claim 2, wherein the detection circuit (rexel) comprises a first switch (T_{/RSbis}) coupling one of the terminals between the source and the drain of the fifth MOS transistor (T_{Rbis}) to the source of the first reference potential (VDD) and a second switch (T_{RSbis}) coupling the other terminal between the source and the drain of the fifth MOS transistor (T_{Rbis}) to a source of a second reference potential (GND).

10. A method of image acquisition by an image sensor (20) comprising pixels (Pix), each pixel comprising a photodetector (PH) and a circuit for reading out the quantity of charges collected by the photodetector at the end of a phase (IP) of charge collection by the photodetector, the method comprising the following steps, carried out for at least one of the pixels:
a) detecting, at least at each of two different times during said phase, whether the quantity of charges collected at said time by the photodetector of said pixel exceeds a threshold; and
b) in the case where the quantity of charges collected at said time by the photodetector exceeds the threshold, storing a first signal (OUT_Tint_PIX) representative of said time and resetting the photodetector, wherein, for each pixel (Pix), the readout circuit comprises at least one first transistor (T_{G1}) coupling the photodetector (PH) to a first node (SN), wherein each pixel (Pix) further comprises a second transistor (T_{AB}) coupling the photodetector to a second node (SNbis), said second node of at least one of the pixels being coupled to the detection circuit (rexel) .

11. The method of claim 10, wherein, at step a), at each of said times, the second transistor is made at least partially conductive, the first transistor being non-conductive, and wherein, at step b), in the case where the quantity of charges collected at said time exceeds said threshold, the second transistor is made conductive to reset the photodetector.
